# EUROPÄISCHE PATENTANMELDUNG

(11) **EP 0 534 113 A2**
(43) Veröffentlichungstag der Anmeldung: **31.03.1993**
(21) Anmeldenummer: 92113678.4
(22) Anmeldetag: 11.08.1992
(51) Int. Cl.: H02H 11/00, H02H 7/26, G01R 27/16, H02H 3/00

(54) **Anordnung zur schnellen Erkennung von Kurzschlüssen**

(30) Priorität: 28.08.1991 DE 4128619
(71) Anmelder: SIEMENS AKTIENGESELLSCHAFT, D-80333 München (DE)
(72) Erfinder: Fischer, Bruno, Dipl.-Ing., W-2000 Hamburg 65 (DE); Newerla, Klaus, Dipl.-Ing., W-8500 Nürnberg (DE); Nippert, Thomas, Dipl.-Ing., W-2000 Hamburg 70 (DE); Richter, Horst, Dipl.-Ing., W-2000 Hamburg 70 (DE); Trenkler, Gerhard, Prof.Dr.Ing., W-2000 Hamburg-Barsbüttel (DE)

(57) **Zusammenfassung**

Die Erfindung betrifft eine Anordnung zur schnellen Erkennung von Kurzschlüssen und zur Erzeugung eines elektrischen Auslösebefehls mit einer elektronischen Meß- und Verarbeitungsanordnung, die in einer Vergleichsschaltung mit voreingestellten Grenzwerten verglichen den Auslösebefehl abgibt, wobei die Meßanordnung sowohl die zeitlichen Verläufe der Spannung als auch des Stromes mißt und die komplexe Leistung ermittelt, wobei mit analoger Vorverarbeitung und anschließender digitaler Weiterverarbeitung die Realteile sowie die Beträge der komplexen Leistungen und der komplexen Leitwerte und der Leistungsfaktor ermittelt werden.

## Beschreibung

Die Erfindung bezieht sich auf eine Anordnung zur schnellen Erkennung von Kurzschlüssen und zur Erzeugung eines elektrischen Auslösebefehls mit einer elektronischen Meß- und Verarbeitungsanordnung, die in einer Vergleichsschaltung mit voreingestellten Grenzwerten verglichen den Auslösebefehl abgibt, wobei die Meßanordnung sowohl die zeitlichen Verläufe der Spannung als auch des Stromes mißt und die komplexe Leistung ermittelt.

Bei einer bekannten Anordnung der obengenannten Art (DE-OS 36 24 400) werden die Zeitverläufe von Strom und Spannung beispielsweise mit Analog-Digital-Wandlern in digitale Zeitreihen umgesetzt, diese digitalen Zahlenfolgen in eine zeitliche Folge von Segmenten zerlegt und durch Anwendung der diskreten Fourier-Transformation auf die Zeitverläufe der Segmente in den Frequenzbereich transformiert. Mit den Fouriertransformierten der Segmente erfolgt dann die Berechnung der komplexen Produkte und Quotienten, die zur Anlagenklassifikation benutzt werden. Alle Berechnungen und damit auch die Bildung der Fouriertransformierten werden mit digitalen Funktionsbausteinen durchgeführt. Für eine schnelle Klassifikation sind erheblich über der Netzfrequenz liegende Frequenzkomponenten in Strom und Spannung erforderlich. Die für eine schnelle und sichere Auswertung dieser Frequenzkomponenten notwendigen digitalen Funktionsbausteine mit entsprechend hoher Leistungsfähigkeit bedeuten einen großen finanziellen Aufwand, außerdem ist eine Anordnung der obengenannten Art ein sehr komplexes System, das einen großen Entwicklungsaufwand zur Sicherstellung einer geringen Falschalarmrate erfordert. Deshalb ist ein Einsatz dieser Anordnung nur an wenigen exponierten Stellen eines Verteilungsnetzes für elektrische Energie sinnvoll.

Der vorliegenden Erfindung liegt die Aufgabe zugrunde, eine Anordnung der obengenannten Art zu schaffen, bei der unter Vermeidung der beschriebenen Nachteile eine schnelle und sichere Klassifizierung des Anlagenzustandes ohne wesentlichen Aufwand erfolgt.

Dies wird auf einfache Weise dadurch erreicht, daß mit analoger Vorverarbeitung und anschließender digitaler Weiterverarbeitung die Realteile sowie die Beträge der komplexen Leistungen und der komplexen Leitwerte und der Leistungsfaktor ermittelt werden.

Es ist an sich eine Anordnung zur Beeinflussung eines Schaltgerätes in Abhängigkeit von Netzzustandsdaten durch eine Impedanzmeßeinrichtung mit einer Verarbeitungsstufe, die in Abhängigkeit von vorgegebenen Impedanzwerten die Einschaltung des Schaltgerätes blockiert, bekannt (DE-OS 33 47 209), jedoch gibt die hier vorgenommene Impedanzmessung keine Angaben über alle umgesetzten Leistungen. Ist eine Anordnung zur Filterung des gemessenen Stromes und der gemessenen Spannung vor den nachfolgenden Untersuchungen vorhanden, wobei die Filtercharakteristik so gewählt ist, daß die Netzfrequenz außerhalb des Durchlaßbereiches liegt, vorhanden, so ist eine Beschränkung auf ein enges Frequenzband möglich und damit eine Vergrößerung des Abstandes zur störenden Grundschwingung. Mit kritisch gedämpften Filtern tritt ein periodisches Einschwingen nicht auf, so daß die Detektion sehr steilflankiger Signale am geringsten verfälscht wird.

Für die Ermittlung der Leitwerte und Leistungen des selektierten Frequenzbereichs ist es vorteilhaft, wenn eine Anordnung zur Berechnung der quadratischen Mittelwerte aus den Verläufen von Strom und Spannung vorhanden ist. Die Bewertung des Anlagenzustandes aus den Leitwerten, Leistungen und Leistungsfaktoren selektierter Frequenzbänder wird dadurch besonders einfach, daß eine Anordnung vorhanden ist, die zur Bildung der Momentanleistung des selektierten Frequenzbereiches die gefilterten Zeitverläufe von Strom und Spannung multipliziert. Weiter ist es für die Detektion der Änderungen des Anlagenzustandes von Vorteil, wenn eine Anordnung vorgesehen ist, die aus der Momentanleistung durch Bildung der Kurzzeitmittelwerte die Wirkleistungen des selektierten Frequenzbereiches bestimmt. Die Verwendung von Kurzzeitmittelwerten ist an sich bekannt (Philippow, Taschenbuch der Elektrotechnik, Band 3, Verlag Technik Berlin 1969, S. 126 ff.). Um eine schnelle und sichere Detektion zu erreichen, ist es von Vorteil, wenn eine Anordnung vorgesehen ist, die aus der Wirkleistung und den quadratischen Mittelwerten der gefilterten Spannung die Wirkleitwerte des selektierten Frequenzbandes berechnet. Eine schnelle Bestimmung des Anlagenzustandes wird erreicht, wenn eine Anordnung zur Ermittlung der Scheinleistung aus den quadratischen Mittelwerten von Strom und Spannung vorhanden ist. Für die Bestimmung des Anlagenzustandes ist es vorteilhaft, wenn eine Anordnung zur Ermittlung des Betrages des komplexen Leitwerts aus den quadratischen Mittelwerten von Strom und Spannung vorgesehen ist. Eine weitere Erhöhung der Detektionssicherheit wird besonders einfach erreicht, wenn eine Anordnung zur Berechnung des Leistungsfaktors aus Wirkleitwert und Betrag des komplexen Leitwertes vorhanden ist. Die Reproduzierbarkeit der für Leistungen, Leitwerte und Leistungsfaktor erhaltenen Ergebnisse wird deutlich erhöht, wenn die gefilterten Verläufe von Strom und Spannung mit Analog-Digital-Wandlern in zeitdiskerte, amplitudenquantisierte Wertefolgen umgesetzt werden, so daß die weiteren Untersuchungen mit digitalen Funktionsbausteinen erfolgen können. Die für die Klassifizierung des Anlagenzustandes notwendige Bewertung der ermittelten Leistungen, Leitwerte und des Leistungsfaktors des selektierten Frequenzbereiches wird besonders einfach, wenn eine Anordnung vorgesehen ist, die die ermittelten Leistungen, Leitwerte und den Leistungsfaktor zu einem Entscheidungsvektor zusammenfaßt. Für eine sichere Detektion von Kurzschlüssen und Lastschaltungen ist es von Vorteil, wenn eine Anordnung vorgesehen ist, die die Parameter des Entscheidungsvektors mit voreingestellten Werten vergleicht und damit den Anlagenzustand klassifiziert. Der Schutz des überwachten Anlagenteils wird besonders einfach, wenn eine Anordnung vorhanden ist, die bei der Detektion eines kritischen Anlagenzustandes einen elektrischen Auslösebefehl abgibt. Eine Erhöhung der Detektionssicherheit wird dadurch erreicht, daß mehrere Anordnungen vorhanden sind, die aus mehreren selektierten Frequenzbändern die Wirkleistungen und -leitwerte, Beträge der komplexen Leitwerte und Leistungen sowie die Leistungsfaktoren ermittelt und zu mehreren Entscheidungsvektoren zusammenfaßt. Für eine schnelle und sichere Klassifikation des Anlagenzustandes ist es vorteilhaft, wenn eine Anordnung zur parallelen Bewertung der Parameter der Entscheidungsvektoren der selektierten Frequenzbänder vorgesehen ist. Eine genauere Klassifizierung eines Anlagenzustandes wird erreicht, wenn eine Anordnung zur Bewertung der zeitlichen Verläufe der berechneten Leistungen, Leitwerte und Leistungsfaktoren vorhanden ist. Als vorteilhaft hat sich herausgestellt, wenn die Multiplizierer als Betragsbildner aufgebaut sind und wenn der Betrag der Ströme und Spannungen als Näherungswert für die Effektivwerte benutzt wird. Als vorteilhaft hat sich ein Verfahren zur schnellen Erkennung von Kurzschlüssen und zur Erzeugung eines elektrischen Auslösebefehls herausgestellt, das darin besteht, daß nach Digitalisierung der Zeitreihen für Spannung und Strom u_{f}(nT), i_{f}(nT) aus diesen die Momentanleistungen sowie die quadratischen Verläufe u_{f}²(nT) bzw. i_{f}²(nT) gebildet werden, wonach diese in Filtereinheiten einer Kurzzeitmittelung zur Bestimmung der Wirkleistung bzw. der quadratischen Mittelwerte unterzogen werden, wonach aus der Wirkleistung und dem quadratischen Mittelwert der Spannung die Ermittlung des Wirkleitwertes und aus den quadratischen Mittelwerten der gefilterten Verläufe von Strom und Spannung der Betrag des Leitwertes und der Scheinleistung sowie des Leistungsfaktors aus dem Wirkleitwert und dem Betrag des Leitwertes erfolgt, wonach der Vergleich der errechneten Parameter mit voreingestellten Grenzwerten zur Bildung eines Auslösebefehls für den Leistungsschalter erfolgt.

Anhand der Zeichnungen wird ein Ausführungsbeispiel gemäß der Erfindung beschrieben.

Es zeigen:
- FIG 1: schematisch einen durch einen Leistungsschalter geschützten Abgang mit n Verbrauchern,
- FIG 2: ein Signalverarbeitungsschema gemäß der Erfindung.

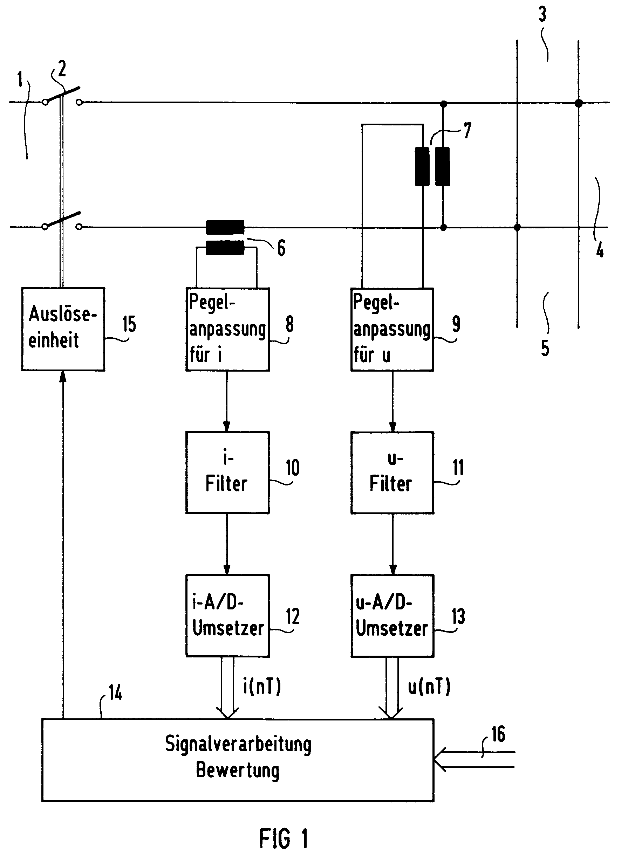

Der in FIG 1 dargestellte Niederspannungsabgang ist an die Niederspannungsverteilung 1 über den Leistungsschalter 2 angeschaltet. Im Ausführungsbeispiel sind die Verbraucher 3, 4 und 5 angedeutet. Der Strom i nach dem Leistungsschalter 2 wird über einen Stromwandler 6 und die Spannung u des Anlagenteiles über einen Spannungswandler 7 erfaßt. Die an die Sekundärseiten des Strom- bzw. Spannungswandlers angeschlossenen Anordnungen 8 und 9 sorgen für die Anpassung der Pegel an die Aussteuerbereiche der nachfolgenden elektronischen Funktionsbausteine. Die Filter 10 und 11 selektieren aus den Zeitverläufen von Strom und Spannung ein bestimmtes Frequenzband. Die Analog-Digital-Wandler 12 und 13, die die gefilterten Verläufe von Strom und Spannung in amplitudenquantisierte, zeitdiskrete Wertefolgen umsetzen, stehen mit einer Signalverarbeitungsschaltung 14 in Verbindung, die ihrerseits auf eine Auslöseeinheit 15 einwirkt, die mit dem Leistungsschalter 2 in Verbindung steht. Der Leistungsschalter 2 kann dabei auch ein elektronischer Schalter, beispielsweise ein Thyristor sein. Die Voreinstellung für die Signalverarbeitungsschaltung 14 ist durch einen Pfeil 16 angedeutet. In der Signalverarbeitungsschaltung 14 wird mittels fest- oder speicherprogrammierbarer Bauelemente eine Identifikation und Klassifizierung der hinter den Wandlern 6, 7 vorhandenen Anlagenzustände anhand geeigneter Parameter durchgeführt, wobei nach einem Vergleich mit den voreingestellten Parametern durch Bewertung auf Kurzschluß erkannt und ein Befehl zum Auslösen des Leistungsschalters 2 erzeugt wird.

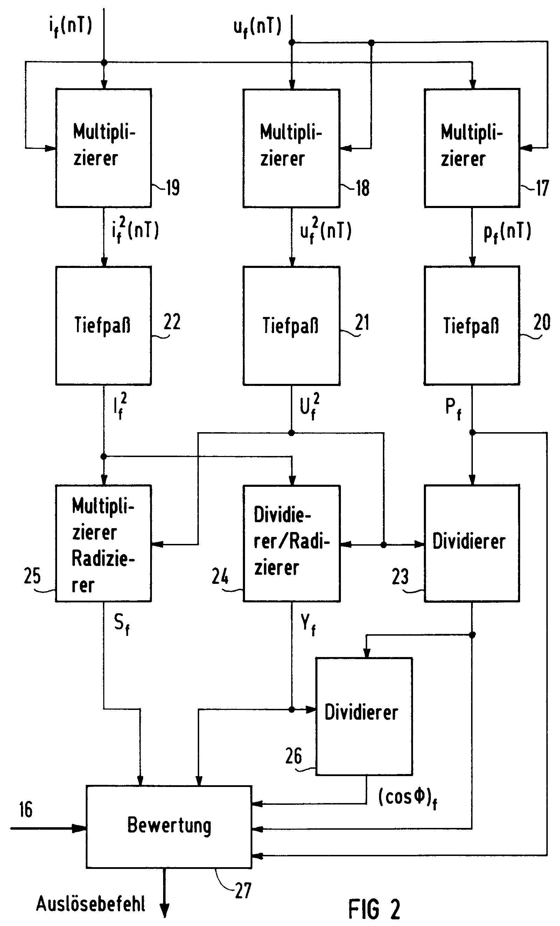

Eine mögliche Wirkungsweise der Signalverarbeitung 14 ist in FIG 2 dargestellt. Zuerst werden von digitalen Zeitreihen u_{f}(nT), i_{f}(nT) im Funktionsblock 17 die Momentanleistung u_{f}(nT).i_{f}(nT) und in den Funktionsblöcken 18 und 19 die quadratischen Verläufe u_{f}²(nT) bzw. i_{f}²(nT) berechnet. Die Ausgangssignale der Funktionsblöcke 17 bis 19 werden in den Filtereinheiten 20 bis 22 einer Kurzzeitmittelung zur Bestimmung der Wirkleistung bzw. der quadratischen Mittelwerte unterzogen. Mit der Wirkleistung liegt bereits ein Parameter vor, der zur Bewertung des Anlagenzustandes benutzt wird (s.Kasten 27). Aus der Wirkleistung und dem quadratischen Mittelwert der Spannung erfolgt im Funktionsblock 23 die Ermittlung des Wirkleitwerts, während aus den quadratischen Mittelwerten der gefilterten Verläufe von Strom und Spannung im Funktionsblock 24 der Betrag des Leitwerts und im Funktionsblock 25 die Scheinleistung gebildet wird. Damit sind bereits vier der fünf zur Bewertung des Anlagenzustandes herangezogenen Parameter berechnet. Es fehlt noch der Leistungsfaktor, dessen Bestimmung aus Wirkleitwert und Betrag des Leitwertes im Funktionsblock 26 erfolgt. Die Bewertung der berechneten Parameter durch Vergleich mit den voreingestellten Grenzwerten, dargestellt durch den Pfeil 16, wird im Funktionsblock 27 vorgenommen, so daß im Kurzschlußfall ein Auslösebefehl für den Leistungsschalter 2 abgegeben wird.

Eine Vereinfachung im Aufbau der Anordnung läßt sich erreichen, wenn mann die Effektivwerte u_{f} und i_{f,} die ja bekanntlich quadratische Mittelwerte sind, durch die Beträge ermittelt, indem man die Multiplizierer 18, 19 durch Betragsbildner wie Vollweg- oder Brückengleichrichter ersetzt.

## Patentansprüche

1. Anordnung zur schnellen Erkennung von Kurzschlüssen und zur Erzeugung eines elektrischen Auslösebefehls mit einer elektronischen Meß- und Verarbeitungsanordnung, die in einer Vergleichsschaltung mit voreingestellten Grenzwerten verglichen den Auslösebefehl abgibt, wobei die Meßanordnung sowohl die zeitlichen Verläufe der Spannung als auch des Stromes mißt und die komplexe Leistung ermittelt, **dadurch gekennzeichnet**, daß mit analoger Vorverarbeitung und anschließender digitaler Weiterverarbeitung die Realteile sowie die Beträge der komplexen Leistungen und der komplexen Leitwerte und der Leistungsfaktor ermittelt werden.

2. Anordnung nach Anspruch 1, **dadurch gekennzeichnet**, daß eine Anordnung (10, 11) zur Filterung des gemessenen Stromes und der gemessenen Spannung vor den nachfolgenden Untersuchungen vorhanden ist, wobei die Filtercharakteristik so gewählt ist, daß die Netzfrequenz außerhalb des Durchlaßbereiches liegt.

3. Anordnung nach den Ansprüchen 1 oder 2, **dadurch gekennzeichnet**, daß eine Anordnung (10, 11) zur Filterung des gemessenen Stromes und der gemessenen Spannung vorhanden ist, die aus den Verläufen des gemessenen Stromes und der gemessenen Spannung ein vorbestimmtes Frequenzband selektiert.

4. Anordnung nach Anspruch 3, **dadurch gekennzeichnet**, daß das Filter (10, 11) kritisch gedämpft ist.

5. Anordnung nach einem der vorhergehenden Ansprüche, **dadurch gekennzeichnet**, daß eine Anordnung (17) zur Berechnung der Momentanleistung aus den Verläufen von Strom und Spannung vorhanden ist.

6. Anordnung nach Anspruch 4, **dadurch gekennzeichnet**, daß eine Anordnung (20) zur Ermittlung der Wirkleistung aus der Momentanleistung vorhanden ist.

7. Anordnung nach den Ansprüchen 1 bis 3, **dadurch gekennzeichnet**, daß eine Anordnung (18, 21, 19, 22) zur Berechnung der quadratischen Mittelwerte aus den Verläufen von Strom und Spannung vorhanden ist.

8. Anordnung nach den Ansprüchen 6 oder 7, **dadurch gekennzeichnet**, daß eine Anordnung (23) zur Berechnung des Wirkleitwerts aus der Wirkleistung und dem quadratischen Mittelwert der Spannung vorhanden ist.

9. Anordnung nach Anspruch 7, **dadurch gekennzeichnet**, daß eine Anordnung (24) zur Berechnung des Betrages des Leitwertes aus den quadratischen Mittelwerten von Strom und Spannung vorhanden ist.

10. Anordnung nach Anspruch 7, **dadurch gekennzeichnet**, daß eine Anordnung (25) zur Berechnung der Scheinleistung aus den quadratischen Mittelwerten von Strom und Spannung vorhanden ist.

11. Anordnung nach einem der vorhergehenden Ansprüche, **dadurch gekennzeichnet**, daß eine Anordnung (26) zur Berechnung des Leistungsfaktors aus dem Wirkleitwert und dem Betrag des Leitwerts vorhanden ist.

12. Anordnung nach Anspruch 1, 2 oder 3, **dadurch gekennzeichnet**, daß eine Anordnung vorgesehen ist, die die gefilterten Verläufe von Strom und Spannung in amplitudenquantisierte, zeitdiskrete Wertefolgen umwandelt, so daß die folgenden Untersuchungen mit digitalen Funktionsbausteinen durchgeführt werden können.

13. Anordnung nach einem der vorhergehenden Ansprüche, **dadurch gekennzeichnet**, daß eine Anordnung (27) vorgesehen ist, die die ermittelten Leistungen und Leitwerte sowie den Leistungsfaktor zu einem Entscheidungsvektor zusammenfaßt.

14. Anordnung nach dem Anspruch 13, **dadurch gennzeichnet**, daß eine Anordnung vorgesehen ist, die die Parameter des Entscheidungsvektors mit vorbestimmten Werten vergleicht und damit den Anlagenzustand klassifiziert.

15. Anordnung nach einem der vorhergehenden Ansprüche, **dadurch gekennzeichnet,** daß mehrere Anordnungen vorgesehen sind, die aus mehreren selektierten Frequenzbändern die Wirkleistungen und -leitwerte, die Beträge der komplexen Leitwerte und Leistungen sowie die Leistungsfaktoren ermitteln und zu mehreren Entscheidungsvektoren zusammenfassen.

16. Anordnung nach Anspruch 15**, dadurch gekennzeichnet**, daß eine Anordnung zur Bewertung der Parameter des Entscheidungsvektors der Selektierten Frequenzbänder vorgesehen ist.

17. Anordnung nach einem der vorhergehenden Ansprüche, **dadurch gekennzeichnet,** daß eine Anordnung zur Bewertung des zeitlichen Verlaufs der Parameter des Entscheidungsvektors vorgesehen ist.

18. Anordnung nach Anspruch 6, **dadurch gekennzeichnet**, daß die Multiplizierer (18, 19) als Betragsbildner aufgebaut sind und daß der Betrag der Ströme und Spannungen als Näherungswert für die Effektivwerte benutzt wird.

19. Verfahren zur schnellen Erkennung von Kurzschlüssen und zur Erzeugung eines elektrischen Auslösebefehls in einer elektrischen Meß- und Verarbeitungsanordnung, **dadurch gekennzeichnet**, daß nach Digitalisierung der Zeitreihen für Spannung und Strom u_{f}(nT), i_{f}(nT) aus diesen die Momentanleistungen (17) sowie die quadratischen Verläufe u_{f}²(nT) bzw. i_{f}²(nT) (18, 19) gebildet werden, wonach diese in Filtereinheiten (20, 21, 22) einer Kurzzeitmittelung zur Bestimmung der Wirkleistung bzw. der quadratischen Mittelwerte unterzogen werden, wonach aus der Wirkleistung und dem quadratischen Mittelwert der Spannung die Ermittlung des Wirkleitwertes (23) und aus den quadratischen Mittelwerten der gefilterten Verläufe von Strom und Spannung der Betrag des Leitwertes (24) und der Scheinleistung (25) sowie des Leistungsfaktors (26) aus dem Wirkleitwert und dem Betrag des Leitwertes erfolgt, wonach der Vergleich der errechneten Parameter mit voreingestellten Grenzwerten zur Bildung eines Auslösebefehls für den Leistungsschalter erfolgt.
